(19) Europäisches Patentamt
European Patent Office
Office européen des brevets

(11) **EP 4 456 159 A1**

(12) **EUROPEAN PATENT APPLICATION**

(43) Date of publication:
**30.10.2024   Bulletin 2024/44**

(21) Application number: **24172197.6**

(22) Date of filing: **24.04.2024**

(51) International Patent Classification (IPC):
**H01L 33/54** $^{(2010.01)}$       **H01L 33/60** $^{(2010.01)}$

(52) Cooperative Patent Classification (CPC):
**H01L 33/60; H01L 33/54;** H01L 2933/0091

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **25.04.2023   US 202363461616 P**
**29.02.2024   US 202463559434 P**
**18.04.2024   US 202418639194**

(71) Applicant: **Seoul Semiconductor Co., Ltd.**
**Ansan-si, Gyeonggi-do 15429 (KR)**

(72) Inventors:
• **JANG, BoRaml**
**15429 Ansan-si (KR)**
• **CHOI, EunMi**
**15429 Ansan-si (KR)**

(74) Representative: **Stolmár & Partner**
**Patentanwälte PartG mbB**
**Blumenstraße 17**
**80331 München (DE)**

(54) **LIGHT EMITTING DEVICE**

(57)     Provided is a light emitting device. The light emitting device comprises a light emitting source (120) comprising a light emitting semiconductor device; a reflector (130) disposed on a side region of the light emitting source (120) while at least partially adjoining the side region of the light emitting source (120); a front-light extractor (140) disposed on the light emitting source (120) and the reflector (130) and comprising a body (140a) including a first curved shape; and a substrate (110) including an upper surface on which the light emitting source (120), the reflector (130), and the front-light extractor (140) are mounted. The reflector (130) comprises a first reflective surface (130a) in at least a region thereof and including a second curved shape, and the second curved shape of the first reflective surface (130a) includes a radius of curvature (R2) greater than or equal to a radius of curvature (R1) of the first curved shape of the front-light extractor (140).

【FIG. 2】

EP 4 456 159 A1

# Description

[Technical Field]

The following description relates to a light emitting device, more particularly to a light emitting device including a light emitting semiconductor device.

[Background Art]

A light emitting diode (LED) is an inorganic semiconductor device that emits light generated through recombination of electrons and holes, and has recently been used in many fields, such as display devices, vehicular lamps, general lighting, and the like. Since light emitting diodes have long lifespan, low power consumption, and fast response time, light emitting devices including such light emitting diodes are expected to replace conventional light sources.

A light emitting diode package produced and implemented in packaged form includes a light emitting diode chip, a substrate for mounting the light emitting diode chip, electrodes for applying electric current to the light emitting diode chip, moldings for protecting the light emitting diode chip, and optical lenses.

For light emitting diode packaging, it is an important issue to extract light as much as possible from the light emitting diode chip and various studies have been made to further improve light extraction efficiency.

[Disclosure]

[Technical Problem]

Exemplary embodiments provide a light emitting device that can minimize or reduce light loss while improving light extraction efficiency.

Exemplary embodiments provide a light emitting device that can delay moisture penetration while improving reliability through increase in length of a moisture penetration path.

Exemplary embodiments provide a light emitting device that can reduce stress caused by external pressure while improving structural stability.

Exemplary embodiments provide a light emitting device that can improve light stability while preventing discoloration by increasing yellowing resistance.

Exemplary embodiments provide a light emitting device that can improve light output by reducing side emitting light loss of a light emitting source.

Exemplary embodiments provide a light emitting device that can improve color purity by reducing chromatic aberration of side emitting light of a light emitting source.

[Technical Solution]

According to one or more embodiments of the present disclosure, a light emitting device may include a light emitting source including a light emitting semiconductor device; a reflector disposed on a side region of the light emitting source while at least partially adjoining the side region of the light emitting source; a front-light extractor disposed on the light emitting source and the reflector, and including a body comprising a first curved shape; and a substrate including an upper surface on which the light emitting source, the reflector, and the front-light extractor are mounted. The reflector may include a first reflective surface formed in at least a region thereof and comprising a second curved shape. The second curved shape of the first reflective surface may include a radius of curvature greater than or equal to a radius of curvature of the first curved shape of the front-light extractor.

A beam angle of light emitted from the light emitting device may range from 15 degrees to 180 degrees with respect to a center of the front-light extractor.

A distance from an upper surface of the light emitting source to an apex of the first convex shape may correspond to the radius of curvature of the first convex shape.

The reflector may include a horizontal cross-sectional area gradually decreasing with increasing vertical distance from the upper surface of the substrate.

The front-light extractor may further include the body including the first curved shape, a spacer extending from a lower distal end of the first curved shape in a vertical direction, and a neck disposed between the spacer and the body.

The body, neck, and spacer may be integrally formed with each other and may include the same material.

The sum of a thickness of the spacer and a thickness of the neck with respect to the substrate may be greater than or equal to a thickness of the light emitting source.

A circumference of a first horizontal cross-section of the neck in a region adjoining the body may be less than a circumference of a second horizontal cross-section of the neck in a region adjoining the spacer.

The neck may include a third curved shape formed in at least a region thereof, and the third curved shape may include a smaller radius of curvature than the first curved shape.

The neck may include a third curved shape, wherein the first curved shape may comprise a radius of curvature five or more times the radius of curvature of the third curved shape.

The radius of curvature of the first curved shape may be four or more times the thickness of the light emitting source.

The second curved shape may include a region of an ascending slope toward a center of the body.

The reflector may include a thickness gradually decreasing with increasing distance from a center of the light emitting source.

At least one side of the light emitting semiconductor device may include a first length (d1) and the first curved shape may include a first radius of curvature (R1), in which the first length (d1) and the first radius of curvature (R1) may satisfy a relational equation of $-0.2083 \times (R1/d1)^2 + 0.5893 \times (R1/d1) + 0.6189 \geq 0.95$ or the first length (d1) and the first radius of curvature (R1) satisfy the condition $0.5 \leq R1/d1 \leq 2.5$, preferably $0.75 \leq R1/d1 \leq 2.0$.

A difference between a distance from the upper surface of the light emitting source to the apex of the body of the front-light extractor and the radius of curvature R1 may be less than 10%.

According to one or more embodiments of the present disclosure, a light emitting device may include: a light emitting source including a light emitting semiconductor device; a reflector disposed on a side region of the light emitting source while at least partially adjoining the side region of the light emitting source; a front-light extractor disposed on the light emitting source and the reflector and including a body comprising a first curved shape; and a substrate including an upper surface on which the light emitting source, the reflector, and the front-light extractor are mounted. The front-light extractor may include the body comprising the first curved shape, a spacer extending from a lower distal end of the first curved shape in a vertical direction, and a neck disposed between the spacer and the body. The sum of a thickness of the spacer and a thickness of the neck with respect to the upper surface of the substrate may be greater than or equal to a thickness of the light emitting source.

The body, the neck and the spacer may be integrally formed with each other and may include the same material.

A circumference of a first horizontal cross-section of the neck in a region adjoining the body may be less than a circumference of a second horizontal cross-section of the neck in a region adjoining the spacer.

The first curved shape may include a radius of curvature four or more times a thickness of the light emitting source.

A distance from an upper surface of the light emitting source to an apex of the first curved shape may correspond to the radius of curvature of the first curved shape.

The reflector may include a horizontal cross-sectional area gradually decreasing with increasing vertical distance from the upper surface of the substrate.

At least one side of the light emitting semiconductor device may include a first length (d1) and the first curved shape may comprise a first radius of curvature (R1), in which the first length (d1) and the first radius of curvature (R1) may satisfy a relational equation of $-0.2083 \times (R1/d1)^2 + 0.5893 \times (R1/d1) + 0.6189 \geq 0.95$ or the first length (d1) and the first radius of curvature (R1) satisfy the condition $0.5 \leq R1/d1 \leq 2.5$, preferably $0.75 \leq R1/d1 \leq 2.0$.

A difference between a distance from the upper surface of the light emitting source to the apex of the body of the front-light extractor and the radius of curvature R1 may be less than 10%.

The reflector may include a first reflective surface formed in at least a region thereof and comprising a second curved shape.

The second curved shape of the first reflective surface may include a radius of curvature greater than or equal to the radius of curvature of the first curved shape of the front-light extractor.

The neck may include a third curved shape formed in at least a region thereof, wherein the third curved shape may include a region of a smaller radius of curvature than the first curved shape.

The neck includes a third curved shape and the first curved shape may comprise a radius of curvature five or more times the radius of curvature of the third curved shape.

According to one or more embodiments of the present disclosure, a light emitting device may include: a light emitting source including a light emitting semiconductor device; a reflector disposed on a side region of the light emitting source while at least partially adjoining the side region of the light emitting source; a front-light extractor disposed on the light emitting source and the reflector and including a first curved shape formed in at least a region thereof; and a substrate including an upper surface on which the light emitting source, the reflector, and the front-light extractor are mounted. At least one side of the light emitting semiconductor device may have a first length (d1) and the first curved shape may include a first radius of curvature (R1), in which the first length (d1) and the first radius of curvature (R1) may satisfy a relational equation of $-0.2083 \times (R1/d1)^2 + 0.5893 \times (R1/d1) + 0.6189 \geq 0.95$ or the first length (d1) and the first radius of curvature (R1) satisfy the condition $0.5 \leq R1/d1 \leq 2.5$, preferably $0.75 \leq R1/d1 \leq 2.0$.

A distance from an upper surface of the light emitting source to an apex of the first curved shape may correspond to a radius of curvature of the first curved shape.

The reflector may include a horizontal cross-sectional area gradually decreasing with increasing vertical distance from the upper surface of the substrate.

The front-light extractor may further include a body comprising the first curved shape, a spacer extending from a lower distal end of the first curved shape in a vertical direction, and a neck disposed between the spacer and the body.

The sum of a thickness of the spacer and a thickness of the neck with respect to the upper surface of the substrate may be greater than or equal to a thickness of the light emitting source and a circumference of a first horizontal cross-section of the neck in a region adjoining the body may be less than a circumference of a second horizontal cross-section of the neck in a region adjoining the spacer.

The reflector may include a first reflective surface formed in at least a region thereof and comprising a second curved shape.

The second curved shape of the first reflective surface may include a radius of curvature greater than or equal to the radius of curvature of the first curved shape of the front-light extractor.

The neck may include a third curved shape formed in at least a region thereof, wherein the third curved shape may include a smaller radius of curvature than the first curved shape.

The neck may include a third curved shape, wherein the first curved shape may include a radius of curvature five or more times the radius of curvature of the third curved shape.

The reflector may include a horizontal cross-sectional area gradually decreasing with increasing vertical distance from the upper surface of the substrate increases.

According to one or more embodiments of the present disclosure, a light emitting device may include: a light emitting source including a light emitting semiconductor device; a reflector disposed on a side region of the light emitting source; a front-light extractor disposed on the light emitting source and the reflector; and a substrate including an upper surface on which the light emitting source, the reflector, and the front-light extractor are mounted. The reflector may include a second curved shape formed in at least a region thereof. The front-light extractor may include a body comprising a first curved shape, a spacer extending from a lower distal end of the first curved shape in a vertical direction, and a neck disposed between the spacer and the body. The neck may include a third curved shape formed in at least a region thereof, wherein the third curved shape may include a smaller radius of curvature than the first curved shape.

The first curved shape may include a radius of curvature five or more times the radius of curvature of the third curved shape.

The reflector may include a first reflective surface formed in at least a region thereof and comprising a second curved shape.

The second curved shape of the first reflective surface may include a radius of curvature greater than or equal to the radius of curvature of the first curved shape of the front-light extractor.

The sum of a thickness of the spacer and a thickness of the neck with respect to the upper surface of the substrate may be greater than or equal to a thickness of the light emitting source.

A circumference of a first horizontal cross-section of the neck in a region adjoining the body may be less than a circumference of a second horizontal cross-section of the neck in a region adjoining the spacer.

A distance from an upper surface of the light emitting source to an apex of the first curved shape may correspond to the radius of curvature of the first curved shape.

The reflector may include a horizontal cross-sectional area gradually decreasing with increasing vertical distance from the upper surface of the substrate increases.

The radius of curvature of the first curved shape may be four or more times the thickness of the light emitting source.

The second curved shape may include a region of an ascending slope toward a center of the body.

The reflector may include a thickness gradually decreasing with increasing distance from a center of the light emitting source.

At least one side of the light emitting semiconductor device may include a first length (d1) and the first curved shape may include a first radius of curvature (R1), in which the first length (d1) and the first radius of curvature (R1) may satisfy a relational equation of $-0.2083 \times (R1/d1)^2 + 0.5893 \times (R1/d1) + 0.6189 \geq 0.95$ or the first length (d1) and the first radius of curvature (R1) satisfy the condition $0.5 \leq R1/d1 \leq 2.5$, preferably $0.75 \leq R1/d1 \leq 2.0$.

A difference between a distance from the upper surface of the light emitting source to the center of the body of the front-light extractor and the radius of curvature R1 may be less than 10%.

According to one or more embodiments of the present disclosure, a light emitting device may include: a light emitting source including a light emitting semiconductor device; a reflector disposed on a side region of the light emitting source; a front-light extractor disposed on the light emitting source and the reflector; and a substrate including an upper surface on which the light emitting source, the reflector, and the front-light extractor are mounted. The front-light extractor may include a body comprising a curved surface, a spacer extending from a lower distal end of the body in a vertical direction, and a neck disposed between the spacer and the body, the neck including inclined regions in some regions of corners thereof.

The reflector may include a horizontal cross-sectional area gradually decreasing with increasing vertical distance from the upper surface of the substrate increases.

Some of the inclined regions of the neck may include a curved region.

Some of the inclined regions of the neck may include a convex region.

The sum of a thickness of the spacer and a thickness of the neck with respect to the upper surface of the substrate may be greater than or equal to a thickness of the light emitting source.

The body may include a thickness greater than or equal to four times the sum of the thickness of the spacer and the thickness of the neck with respect to the upper surface of the substrate.

A circumference of a first horizontal cross-section of the neck in a region adjoining the body may be less than a circumference of a second horizontal cross-section of the neck in a region adjoining the spacer.

The front-light extractor may include a first curved shape and the reflector may include a second curved shape.

The radius of curvature of the first curved shape may be four or more times the thickness of the light emitting source.

The reflector may include a region of a thickness gradually decreasing with increasing distance from a center of the light emitting source.

At least one side of the light emitting semiconductor device may include a first length (d1) and the first curved shape may include a first radius of curvature (R1), in which the first length (d1) and the first radius of curvature (R1) may satisfy a relational equation of $-0.2083 \times (R1/d1)^2 + 0.5893 \times (R1/d1) + 0.6189 \geq 0.95$ or the first length (d1) and the first radius of curvature (R1) satisfy the condition $0.5 \leq R1/d1 \leq 2.5$, preferably $0.75 \leq R1/d1 \leq 2.0$.

A difference between a distance from the upper surface of the light emitting source to a center of the body of the front-light extractor and the radius of curvature R1 may be less than 10%.

The reflector may include a larger volume than the light emitting source.

[Advantageous Effects]

According to one embodiment of the present invention, the light emitting device can minimize light loss while improving light extraction efficiency.

According to one embodiment of the present invention, the light emitting device can delay moisture penetration while improving reliability through increase in length of a moisture penetration path.

According to one embodiment of the present invention, the light emitting device can reduce stress caused by external pressure while improving structural stability.

According to one embodiment of the present invention, the light emitting device can improve light stability and preventing discoloration by increasing yellowing resistance.

According to one embodiment of the present invention, the light emitting device can reduce chromatic aberration of the light emitting device.

[Brief Description of Drawings]

FIG. 1 is a perspective view of a light emitting device according to one exemplary embodiment of the present invention.
FIG. 2 is a sectional view of a light emitting device according to one exemplary embodiment of the present invention, which includes a reflector including a first reflective surface including a convex shape.

FIG. 3 is a sectional view of a light emitting device according to one embodiment of the present invention, which includes a reflector including a first reflective surface including a concave shape.
FIG. 4 is a view of a front-light extractor including a neck comprising an inclined region according to one exemplary embodiment of the present invention.
FIG. 5 is a view of a front-light extractor including a neck comprising a concave region according to one exemplary embodiment of the present invention.
FIG. 6 is a view of a front-light extractor including a neck comprising a convex region according to one embodiment of the present invention.
FIG. 7 is a view of a light emitting source of a light emitting device according to one exemplary embodiment of the present invention.

[Detailed Description]

The present disclosure may be variously modified and realized in many different forms, and thus specific embodiments will be exemplified in the drawings and described in detail herein below. However, in the following description, for the purposes of explanation, numerous specific details are set forth in order to provide thorough understanding of various exemplary embodiments or implementations of the present disclosure. As used herein, "embodiments" and "implementations" are interchangeable terms for non-limiting examples of devices or methods employing one or more of the inventive concepts disclosed herein. It will be apparent, however, that various exemplary embodiments may be practiced without these specific details or with one or more equivalent arrangements. In other instances, well-known structures and devices are shown in block diagram form in order to avoid unnecessarily obscuring various exemplary embodiments. Further, various exemplary embodiments may be different, but do not have to be exclusive. For example, specific shapes, configurations, and characteristics of an exemplary embodiment may be used or implemented in another exemplary embodiment without departing from the inventive concepts.

Unless otherwise specified, the illustrated exemplary embodiments are to be understood as providing exemplary features of varying detail of some ways in which the inventive concepts may be implemented in practice. Therefore, unless otherwise specified, the features, components, modules, layers, films, panels, regions, and/or aspects (hereinafter individually or collectively referred to as "elements") of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, and property of the elements, unless specified. Further, in the accompanying drawings, the size and relative sizes of elements may be exaggerated for clarity and/or descriptive purposes. When an exemplary embodiment is implemented differently, a specific process order may be performed differently from the described order. For example, two consecutively described processes may be performed substantially at the same time or performed in an order opposite the described order. In addition, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, such as the x, y, and z-axes, and may be interpreted in a broader sense. For example, the DR1-axis, the DR2-axis, and the DR3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," and the like may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (for example, as in "sidewall"), and the like, may be used herein for descriptive purposes, and, thereby, to describe one element's relationship to other element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (for example, rotated 90 degrees or at other orientations), and, as such, the spatially relative descriptors used herein may likewise interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various exemplary embodiments are described herein with reference to sectional and/or exploded illustrations that are schematic illustrations of idealized exemplary embodiments and/or intermediate structures. As such, variations from the shapes of the illustrations as a result, for example, of manufacturing techniques and/or tolerances, are to be expected. Thus, exemplary embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some exemplary embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (for example, microcode) to perform various functions discussed herein and may optionally be driven by firmware and/or software. It is also contemplated that each block, unit, and/or module may be implemented by dedicated hardware, or as a combination of dedicated hardware to perform some functions and a processor (for example, one or more programmed microprocessors and associated circuitry) to perform other functions. Also, each block, unit, and/or module of some exemplary embodiments may be physically separated into two or more interacting and discrete blocks, units, and/or modules without departing from the scope of the inventive concepts. Further, the blocks, units, and/or modules of some exemplary embodiments may be physically combined into more complex blocks, units, and/or modules without departing from the scope of the inventive concepts.

Unless otherwise defined, all terms (including technical and scientific terms) used herein have the same meaning as commonly understood by one of ordinary skill in the art to which this disclosure pertains. Terms, such as those defined in commonly used dictionaries, should be interpreted as having a meaning that is consistent with their meaning in the context of the relevant art and should not be interpreted in an idealized or overly formal sense, unless expressly so defined herein.

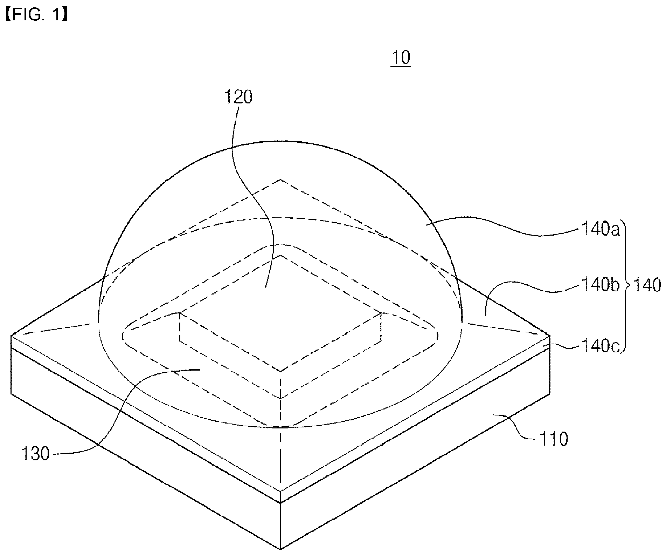

FIG. 1 is a perspective view of a light emitting device 10 according to one embodiment of the present invention.

Referring to FIG. 1, the light emitting device 10 according to an exemplary embodiment includes a substrate 110, a light emitting source 120, a reflector 130, and a front-light extractor 140.

The light emitting source 120, the reflector 130, and the front-light extractor 140 may be mounted on an upper surface of the substrate 110.

The substrate 110 may be formed to have high thermal conductivity and high reflection efficiency (using a material having these properties). For example, the substrate 110 may be formed of aluminum nitride (AlN) ceramics or $Al_2O_3$ ceramics, plastics including polymers, and the like. The substrate 110 may be formed of acrylonitrile butadiene styrene (ABS), liquid crystalline polymers (LCPs), polyamide (PA), polyphenylene sulfide (IPS), thermoplastic elastomers (TPEs), or a metal. By way of example, the substrate 110 may have a thermal conductivity of about 170 W/mk. In addition, materials, such as Cu, Ag, Au, Al, and the like, may be added to (e.g., coated or deposited on) the substrate 110 to improve reflection efficiency and the like. However, it should be understood that the substrate 110 is not limited thereto and may be formed of various materials, such as GaAs, GaN, Si, Al, Cu, and/or sapphire. In addition, at least a region of the substrate 110 may have a transmittance of 50% or more to increase a light emission region. The substrate 110 may also have a reflectivity of 50% or more in some region thereof and may allow adjustment of beam angle.

The light emitting source 120 may include at least one light emitting semiconductor device. The light emitting semiconductor device may generate and emit light through an active layer activated upon application of electric current. The light emitting semiconductor device may include an LED chip. The LED chip may be, for example, an LED chip that generates light in a specific wavelength band (e.g., ultraviolet light, blue light, green light, yellow light, red light, infrared light). The light emitting source 120 may have a thickness w2 with respect to the upper surface of the substrate 110 and a side region thereof may have a length d1 in a lateral direction.

The light emitting source 120 may include a plurality of light emitting semiconductor devices. The light emitting source 120 may include two, three, four or more light emitting semiconductor devices, each of which may have a peak wavelength with a difference of less than 10 nm therebetween, thereby realizing high color purity. In addition, the plurality of light emitting semiconductor devices may have different peak wavelengths with a difference of 10 nm or more therebetween, thereby realizing a wide range of colors.

The reflector 130 may surround at least a region of the light emitting source 120. The reflector 130 reflects incident light to the outside of the light emitting device 10. Due to reflection inside the light emitting device 10, at least some fractions of light emitted from the light emitting source 120 may reach the surface of the reflector 130, which may reflect the light towards the front-light extractor 140 to improve light extraction efficiency of the light emitting device 10 and may adjust the beam angle of light emitted from the light emitting device 10. Further, the reflector 130 may adjust a path of side emitting light emitted from the light emitting source 120 to face the front-light extractor 140. Accordingly, light emitted from the light emitting device 10 can increase uniformity of light depending on the beam angle. The reflector 130 may have a light reflectivity of 70% or more with respect to light emitted from the light emitting source 120. For example, the reflector 130 may have a light reflectivity of 80% or more at visible light wavelengths. In addition, the reflector 130 may have a light reflectivity of 90% or more with respect to light in the blue wavelength band, without being limited thereto. The reflector 130 may be composed of a material having light reflectivity with respect to light emitted from the light emitting source 120. The reflector 130 may include a polymer organic compound, such as silicone, an epoxy resin, a polymer, a fluoropolymer resin, and the like, and may further include various additives, such as $TiO_2$, $Ba_2Ti_9O_{20}$, $BaSO_4$, $SiO_2$, $CaCO_3$, ZnO, $CaCO_3$, and the like to improve light reflectivity. In addition, the reflector 130 may also cover at least one side region of the light emitting source 120 to increase the length of a moisture penetration path, thereby delaying moisture penetration while improving reliability. Further, the reflector 130 may cover at least one surface of the substrate 110 to prevent the one surface of the substrate from being discolored by light, thereby improving light safety while reducing yellowing and discoloration.

The front-light extractor 140 may cover at least part of the light emitting source 120 and/or the reflector 130. The front-light extractor 140 may be an optical lens that extracts light emitted from the light emitting source 120 and light reflected from the reflector 130 towards a front or side region of the light emitting device 10 while adjusting the beam angle. The beam angle of the light emitting device 10 may range, for example, from 15 degrees to 180 degrees with respect to the center of the front-light extractor 140, without being limited thereto. The front-light extractor 140 may be formed of a variety of materials, such as phenyl silicone, methyl silicone, epoxy, fused silica, borosilicate, soda-lime glass, aluminosilicate, fluoropolymer, polyphthalamide (PPA), polybutylene terephthalate (PBT), polycarbonate (PC), and the like.

The front-light extractor 140 includes a body 140a including a curved surface. The body 140a of the front-light extractor 140 may include a region of a curved shape (hereinafter, first curved shape), which at least partially or completely covers the light emitting source 120 and the reflector 130. By way of example, the first curved shape may have a dome, hemispherical, or elliptical shape, without being limited thereto, may act as a lens that adjusts the beam angle by adjusting, focusing or diffusing light emitted from the light emitting 120, and may minimize light loss to increase light extraction efficiency.

The front-light extractor 140 may further include at least one of a neck 140b and a spacer 140c. The distinction between the body 140a, the neck 140b, and the spacer 140c on the front-light extractor 140 is for convenience of description only, and, depending on embodiments, the body 140a, neck 140b, and spacer 140c may be integrally formed with each other, may include the same material, and may have reduced interface to reduce the moisture penetration path and delay moisture penetration while improving reliability. On the other hand, at least one of the neck 140b and the spacer 140c may be omitted depending on the size or shape of the body 140a. At least one surface of the body 140a, the neck 140b, and the spacer 140c of the front-light extractor 140 may have a curvature to reduce stress caused by external pressure while improving structural stability.

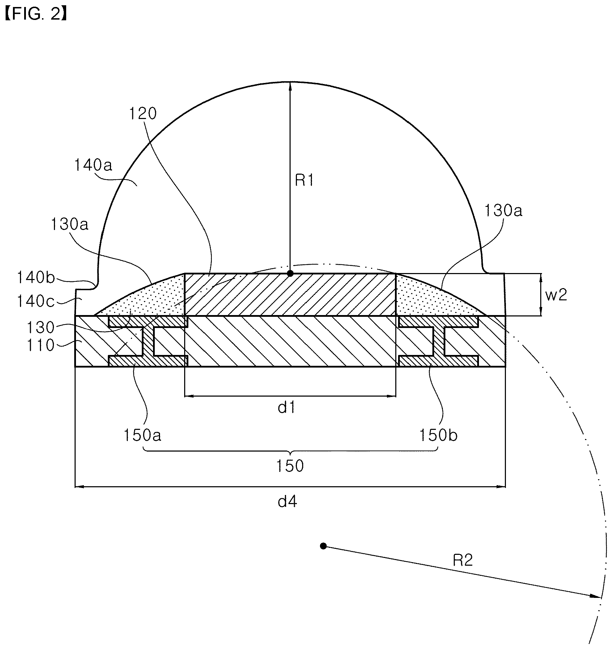

FIG. 2 is a sectional view of the light emitting device 10 according to one exemplary embodiment of the present invention. FIG. 2 may be understood as a more specified example of the light emitting device 10 shown in FIG. 1. Accordingly, repeated description of the configuration mentioned above in FIG. 1 will be omitted and the description with reference to FIG. 1 may be referred to in order to understand the example shown in FIG. 2, even if not otherwise indicated.

Referring to FIG. 2, the substrate 110 may include at least one electrode 150 for applying electric current to the light emitting source 120. The electrodes 150 may include a first electrode 150a and a second electrode 150b. The first electrode 150a and the second electrode 150b are each electrically connected to the light emitting source 120. The light emitting source 120 may include electrodes corresponding to the first electrode 150a and the second electrode 150b. The substrate 110 may include an upper electrode electrically connected to the electrodes of the light emitting source 120, a lower electrode on a lower surface thereof, and a through-electrode electrically connecting the upper electrode to the lower electrode. The light emitting source 120 may be electrically connected to the electrode 150 in various ways including wiring, bonding, soldering, and the like. The electrode 150 may be connected to an external power source to supply electric current to the light emitting source 120. The electrode 150 may be formed of materials with low electrical resistance to increase driving efficiency for smooth current supply and may include at least one of iron, copper, tin, gold, silver, aluminum, metal compounds, metal oxides, graphite, graphene, or anisotropic conductive materials.

In addition, the reflector 120 may be disposed in a region of the electrode 150. The reflector 120 may increase the length of the moisture penetration pathway to the electrode 150 to prevent the electrode 150 from being oxidized by moisture, thereby improving reliability. In addition, the reflector 120 can prevent a region of the electrode from discoloring, thereby reducing yellowing and discoloration through improvement in light stability.

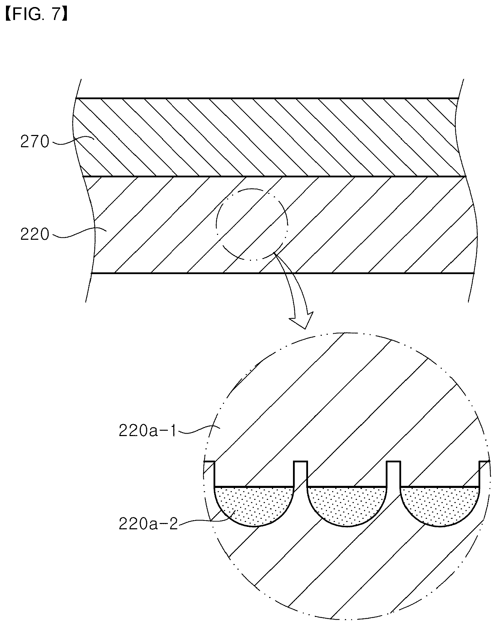

Alternatively, the substrate 10 may include a modified region on at least part of the upper surface thereof. The modified region serves to prevent light from being absorbed into the substrate 110 while (re)reflecting light to the outside, and may be formed of a highly reflective material. For example, the modified region may be composed of a metal, such as Ag, Cu, Au, ENEPIG, ENIG, Al, and the like, or a light dispersing material, such as $TiO_2$, SiN, $BaSO_4$, $Al_2O_3$, and the like. The light emitting semiconductor devices of the light emitting source 120 may be disposed on one or more sides of the modified region and may improve light extraction efficiency through increase in reflectivity of the substrate. The modified region on the upper surface of the substrate 110 of FIG. 2 may be formed, for example, in the same structure as a roughness structure 220a, as shown in FIG. 7, without being limited thereto.

The reflector 130 may at least partially adjoin a side region of the light emitting source 120. The reflector 130 may form a wall/hill surrounding the side region of the light emitting source 120. By way of example, the wall/hill formed by the reflector 130 may be partially spaced apart from the side region of the light emitting source 120 (while partially adjoining the side region thereof). A horizontal cross-sectional area of the wall formed by the reflector 130 may gradually decrease with increasing vertical distance from the upper surface of the substrate 110. At least a region of the wall/hill formed by the reflector 130 may include at least one inclined region. Each inclined region may include at least one of a straight region and/or a curved region. at least one of the inclined regions may include a region of an ascending slope towards the center of the light emitting device 10/body 140a. More preferably, the reflector 130 has a thickness gradually increasing region towards the center thereof and the thickness of the reflector 130 may be secured to increase reflectivity, thereby improving light extraction efficiency.

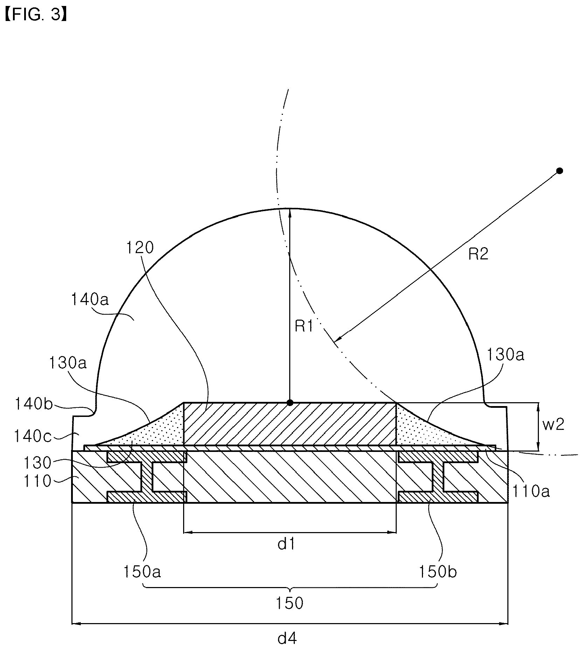

On the other hand, the reflector 130 of the light emitting device 10 is not limited to the shape shown in FIG. 2. For example, the reflector 130 may have a slope or a concave shape that descends with increasing distance from the center thereof, as shown in FIG. 3. More preferably, the reflector 130 has a thickness gradually decreasing with increasing distance from the center thereof. With the reflector 130 having such a descending slope, the light emitting device can achieve the effect of narrowing the beam angle.

The body 140a of the front-light extractor 140 may include a region of a first convex shape having a radius of curvature R1. The radius of curvature R1 of the body 140a may be determined in consideration of a target light beam angle or the like. By way of example, a distance from the upper surface of the light emitting source 120 to an apex of the body 140a of the front-light extractor 140 may correspond to the radius of curvature R1. More specifically, the distance from the upper surface of the light emitting source 120 to the apex of the body 140a of the front-light extractor 140 may be (substantially) equal to the radius of curvature R1. More preferably, the radius of curvature R1 may be a distance from the highest point in a cross-section of the front-light extractor 140 to the upper surface of the light emitting source 120. In addition, the length of the light transmission path within the body 140a may correspond to/be substantially the same as the radius of curvature R1. When the length of the light transmission path is the same as the radius of curvature R1, the light extraction efficiency of the light emitting device can be increased, thereby improving light output.

Hereinafter, for convenience of description, at least one of the light emitting device 10 and/or a light emitting device X0 will be referred to as light emitting device X0. Likewise, the substrate 110, x10, the light emitting source 120, x20, the reflector 130, x30, the front-light extractor 140, x40, the electrode 150, x50, and the like in the light emitting device x0 may be briefly denoted as the substrate x10, the light emitting source x20, the reflector x30, the front-light extractor x40, the electrode x50, respectively, wherein x may mean at least one of 1 or x.

Hereinafter, an example of the reflector x30 applicable to the light emitting device 10 will be described.

At least part of the wall/hill formed by the reflector x30 may include a curved inclined region that ascends toward the center of the light emitting device 10/body x40a or descends toward the outside, in which the curved inclined region may be included in a first reflective surface x30a of the reflector x30. Hereinafter, the radius of curvature of the curved surface with respect to the inclined region of the first reflective surface x30a will be referred to as R2.

Referring to FIG. 2, the reflector 130 may include the first reflective surface 130a that includes a region of a curved shape (hereinafter, a second curved shape).

Although the second curved shape is shown as being formed over the entirety of the first reflective surface x30a for convenience, it should be understood that the present invention is not limited thereto and the second curved shape may be disposed on a portion of the first reflective surface x30a. Although the second curved shape is shown as having a single radius of curvature R2, it should be understood that the present invention is not limited thereto. For example, the second curved shape may include one or more radii of curvature located within a certain range from R2. By way of example, the second curved shape may be defined, for example, by the slope of the first reflective surface x30a. For example, the first reflective surface x30a may include a region where the slope gradually decreases (or saturates) with decreasing distance from the light emitting source x20 in a lateral direction or gradually increases with increasing distance from the light emitting source x20 in the lateral direction.

According to one embodiment, the radius of curvature R2 may be different from the radius of curvature R1 of the body x40a of the front-light extractor x40.

For example, the radius of curvature R2 may be greater than the radius of curvature R1 of the body x40a of the front-light extractor x40. With the radius of curvature R2 greater than the radius of curvature R1, the light emitting device 10 can increase light extraction efficiency in a direction of a target beam angle of light while improving uniformity of light and colors within the light emitting device 10. Furthermore, it is advantageous to improve quality of light by reducing a difference in color temperature depending on the direction of irradiation and the direction of observing light. For example, a light emitting device 10 emitting light with a color temperature of 4500K or higher can have a large difference in color temperature depending on the observing direction. In particular, although light observed at the center of the light emitting device can appear blue and light observed at an outer periphery thereof can appear yellow, the light emitting device 10 according to the embodiment of the present invention can reduce color distortion of a subject by minimizing the difference in color temperature depending on the beam angle or the observing direction.

If the radius of curvature R2 is less than the radius of curvature R1, the transverse thickness of the wall/hill formed by the reflector x30 cannot be sufficiently secured (at least in part) and light emitted from the side region of the light emitting source x20 or reflected from the upper surface of the substrate x10 can transmit the reflector x30. As such, light unintentionally transmitting the reflector x30 can deviate from the direction of the target beam angle, causing final light extracted from the light emitting device 10 to be at least partially uneven in brightness, color and/or quality.

In one embodiment to solve the above problem, the radius of curvature R2 of the first reflective surface x30a of the reflector x30 is greater than the radius of curvature R1 of the body x40a of the front-light extractor x40.

In order to improve light extraction efficiency in the direction of the beam angle, the radius of curvature R1 in the light emitting device 10 may be optimized according to the length d1 of the light emitting source x20. Lens radius optimization efficiency y according to the ratio of the radius of curvature R1 to the length d1 (k = R1/d1) may be expressed as a quadratic function of Equation 1.

[Equation 1]

$$y = -0.2083k^2 + 0.5893k + 0.6189$$

For example, when defining an efficiency y = 100% for k=1, the k value may be determined such that the lens radius optimization efficiency y is greater than or equal to 80% (i.e., greater than or equal to 0.8). For example, if R1 is 1.5 mm for d1 = 1.5 mm, the lens radius optimization efficiency y is 100% and R1 may range from about 1.2 mm to less than 3.6 mm. In this case, the radius of curvature R2 varies depending on the size of the light emitting device 10 and the size of the light emitting source 120. For example, when d1 is 1.5 mm and the size d4 of the light emitting device 10 is 3.5 mm, R2 may range from about 1.5 mm to less than 34.2 mm. By way of example, the R2/R1 ratio may range from about 1.0 to about 25. More specifically, R1 may be about 1.6 mm and R2 may be about 2.5 mm. Alternatively, R1 may be about 1.7 mm and R2 may be about 2.5 mm. And the first length (d1) and the first radius of curvature (R1) satisfy the condition $0.5 \le R1/d1 \le 2.5$, preferably $0.75 \le R1/d1 \le 2.0$.

In the above examples, the volume of the reflector x30 may be determined by way of example according to the sizes of the light emitting source 120 and the light emitting device 10. By way of example, when the substrate 110 of the light emitting device 10 has a size d4 of 3.5 mm × 3.5 mm and the light emitting semiconductor device of the light emitting source 120 has a size of about 1,550 μm × 1,550 μm × 150 μm (i.e., d1= 1,550 μm, w2= 150 μm), the reflector x30 may have a volume of about 0.50 μl to about 1.5 μl, preferably about 1 μl. More preferably, the reflector x30 has a larger volume than the light emitting source 120 and the length of the moisture penetration path is increased to delay moisture penetration while improving reliability.

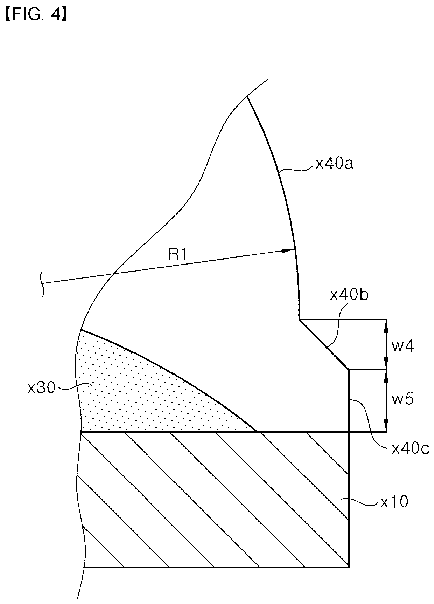

Referring to FIG. 4 to FIG. 6, one example of the front-light extractor 140 applicable to the light emitting device 10 will be described.

The radius of curvature R1 of the body x40a of the front-light extractor 140 may be determined in consideration of at least one of a target beam angle of light or w2. For the light emitting device 10, w2 may refer to a distance from the upper surface of the substrate x10 to the upper surface of the light emitting source 120.

By way of example, it is desirable that the (constant) radius of curvature R1 be maintained from w2 in order to extract light in the direction of the target beam angle of light. In other words, it is desirable that the distance from w2 to the apex of the front-light extractor 140 be substantially equal to the radius of curvature R1. More preferably, a difference between the distance from the apex of the front-light extractor 140 and the radius of curvature R1 is less than 10%.

However, there is a problem in that the corresponding condition is not satisfied when the center of the radius of curvature of the body x40a of the front-light extractor 140 adjoins the upper surface of the substrate x10. In order to solve this problem, according to one embodiment of the invention, the front-light extractor 140 may further include a spacer x40c and/or a neck x40b. The spacer x40c may extend from a lower distal end of the body x40a in the vertical direction and may adjoin the upper surface of the substrate x10. The neck x40b may be disposed between the spacer x40c and the body x40a to connect the spacer x40c to the body x40a.

By way of example, the sum (w4+w5) of the thickness w4 of the neck x40b and the thickness w5 of the spacer x40c may be greater than or equal to the thickness w2 of the light emitting source 120, without being limited thereto. The height of the front-light extractor x40 from the upper surface of the substrate 110 may be w5 + w4 + R1, where R1 may be the thickness of the body 140a. When (w4+w5) is greater than or equal to the thickness w2 of the light emitting source 120, the center of the radius of curvature R1 of the front-light extractor 140 may be flush with or higher than the upper surface of the light emitting source 120 and the light extraction efficiency of the light emitting source 120 can be increased.

By way of example, the relationship R1 ≥ 4 * M may be satisfied. M may be w2 or w5+w4. That is, the thickness of the body may be four or more times the sum of the thicknesses of the neck and the spacer, a light path of the front-light extractor 140 may be sufficiently secured to improve light extraction efficiency, and the beam angle of the light emitting device 10 may become 140 degrees or less.

The neck x40b may include an inclined region that narrows toward the center of the body x40a. For example, the neck x40b may have a horizontal circumference gradually decreasing with increasing distance from the upper surface of the substrate x10. A circumference of a first horizontal cross-section of the neck x40b in a region adjoining the body x40a may be less than a circumference of a second horizontal cross-section of the neck x40b in a region adjoining the spacer x40c, and as the neck x40b narrows toward the center of the body x40a, corner stress applied to the neck x40b can be gradually reduced, thereby reducing delamination or fracture at a corner thereof due to external impact.

The inclined region of the neck x40b may include at least one of a straight region and a curved region.

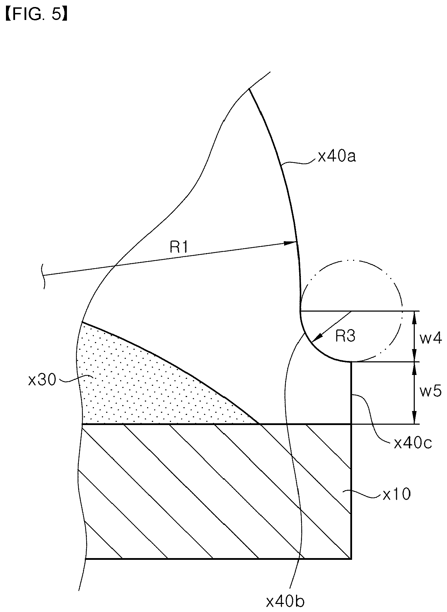

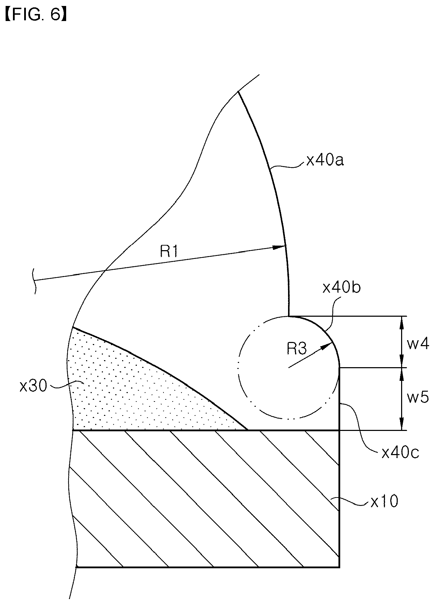

For example, referring to FIG. 4, the inclined region of the neck x40b is simplified to include a straight region. Alternatively, the inclined region of the neck x40b may also include a curved region, as shown in FIG. 5 or FIG. 6.

Referring to FIG. 5, the inclined region of the neck x40b may include a region of a concave shape. Although FIG. 5 illustrates that the concave shape is formed over the entire inclined region of the neck x40b, it should be understood that the present invention is not limited thereto and the concave shape may be formed over a portion of the inclined region of the neck x40b. More preferably, the inclined region of the neck x40b is formed in some region of the corner thereof, thereby relieving corner stress to improve durability while reducing lens detachment or delamination between the spacer x40c and the substrate 110 due to sudden change in ambient temperature.

Although FIG. 5 illustrates that the concave shape of the inclined region of the neck x40b has a single radius of curvature R3, it should be understood that the present invention is not limited thereto. For example, the concave shape may include one or more radii of curvature within a certain range from R3. The radius of curvature R3 may be less than the radius of curvature R1. For example, the radii of curvature R1 and R3 may satisfy the relationship $R1 \geq R3 \times 5$. More specifically, when R1 ranges from about 1.6 mm to 1.7 mm, R3 may range from about 0.1 mm to 0.36 mm, without being limited thereto. By making the radius of curvature R3 less than R1, the body x40a can provide a main light path to allow light emitted from the light emitting device 10 to exit through the body x40a.

By way of example, the inclined region of the neck x40b may be defined by a slope. For example, the neck x40b may include a region where the slope gradually increases with decreasing distance from the center of the light emitting source 120/body x40a in the lateral direction or gradually decreases (saturate) with increasing distance therefrom in the lateral direction, and such a change in slope can reduce stress due to external pressure while improving structural stability.

The curved region of the neck 140b, as shown in FIG. 5, can distribute physical stress (e.g., stress due to heat, pressure, and the like) that can be concentrated on a point where the body x40a meets the spacer x40c, can improve durability, and can reduce lens detachment or delamination between the spacer x40c and the substrate x10 due to sudden change in ambient temperature. Furthermore, this structure provides an advantage of changing the light path inside the spacer x40c to reduce trapping or loss of light inside the spacer x40c, thereby improving luminous efficacy.

In another embodiment, referring to FIG. 6, the inclined region of the neck x40b may include a region of a convex shape. Although FIG. 6 shows a curved shape formed over the entire inclined region of the neck x40b, it should be understood that the present invention is not limited thereto and the curved shape may be formed over a portion of the inclined region of the neck x40b. Although FIG. 6 shows that the curved shape of the inclined region of the neck x40b has a single radius of curvature R3, it should be understood that the present invention is not limited thereto. For example, the curved shape of the inclined region may include one or more radii of curvature within a certain range from R3. The radius of curvature R3 may be less than the radius of curvature R1. For example, the radii of curvature R1 and R3 may satisfy the relationship $R1 \geq R3 \times 5$. More specifically, when R1 ranges from about 1.6 mm to 1.7 mm, R3 may range from about 0.1 mm to 0.36 mm, without being limited thereto. By way of example, the inclined region of the neck x40b may be defined by a slope. For example, the neck x40b may include a region where the slope gradually decreases (saturates) with increasing distance from the center of the light emitting source 120/body x40a in the lateral direction or gradually increases with decreasing distance thereto in the lateral direction. The curved region of the neck x40b, as shown in FIG. 6, can distribute physical stress (e.g., stress due to heat, pressure, and the like) that can be concentrated on the point where the body x40a meets the spacer x40c, can improve durability, and can reduce lens detachment or delamination between the spacer x40c and the substrate x10 due to sudden change in ambient temperature. Furthermore, this structure provides an advantage of changing the light path inside the spacer x40c to reduce trapping or loss of light inside the spacer x40c, thereby improving luminous efficacy.

Furthermore, in the above examples, the light emitting source 220 may include at least one of a roughness structure 220a-1 or a deposition layer 220a-2 covering at least part of the roughness structure 220a-1 inside the light emitting source 220, as shown in FIG. 7, and in some embodiments, the deposition layer 220a-2 or the roughness structure 220a-1 may be omitted. By way of example, the roughness structure 220a-1 may be a patterned sapphire substrate (PSS), a patterned sapphire substrate LED with a $Si_3N_4$ barrier (PSN), a patterned sapphire substrate LED with a $SiO_2$ barrier (PSO), a patterned sapphire with air void (PSA), or the like. By way of example, the deposition layer 220a-2 may be formed through plasma-enhanced chemical vapor deposition (PECVD). Specifically, the deposition layer 220a-2 may be an $SiO_2$, $Si_3N_4$, or AlN layer formed through PECVD. The roughness structure 220a-1 and the deposition layer 220a-2 can improve luminous efficacy by (re)reflecting light emitted/absorbed toward the lower surface of the light emitting source 220 to the upper surface of the light emitting source 220. In particular, such a structure can improve light extraction efficiency (LEE) by 5% or more. On the other hand, the roughness structure 220a-1/deposition layer 220a-2 are not limited to the shapes shown in FIG. 7 and may be replaced by various other shapes, such as an irregular shape, a serrated shape, a conical shape, a trapezoidal shape, a concave shape, and the like.

The detailed description of the exemplary embodiments of the present invention disclosed herein has been provided to allow those skilled in the art to implement and practice the present invention. Although some exemplary embodiments have been described herein with reference to the accompanying drawings, it should be understood that various modifications and changes can be made by those skilled in the art without departing from the spirit and scope of the invention, as defined by the claims and equivalents thereto. For example, those skilled in the art may utilize each of the configurations described in the above embodiments through combination with each other.

Accordingly, the present invention should not be intended to be limited to the embodiments disclosed herein, but rather to give the broadest scope consistent with the principles and novel features disclosed herein.

[List of Reference Numerals]

> 10: Light emitting device
> 110, x10: Substrate
> 120,220: Light emitting source
> 130, x30: Reflector
> 140, x40: Front-light extractor
> 140a, x40a: Body
> 140b, x40b: Neck
> 140c, x40c: Spacer
> 150: Electrode

**Claims**

1. A light emitting device comprising:

   a light emitting source comprising a light emitting semiconductor device;
   a reflector disposed on a side region of the light emitting source while at least partially adjoining the side region of the light emitting source;
   a front-light extractor disposed on the light emitting source and the reflector and comprising a body including a first curved shape; and
   a substrate including an upper surface on which the light emitting source, the reflector, and the front-light extractor are mounted,
   wherein the reflector comprises a first reflective surface in at least a region thereof and including a second curved shape, and the second curved shape of the first reflective surface includes a radius of curvature greater than or equal to a radius of curvature of the first curved shape of the front-light extractor.

2. The light emitting device according to claim 1, wherein a beam angle of the light emitting device ranges from 15 to 180 degrees with respect to a center of the front-light extractor.

3. The light emitting device according to claim 1 or 2, wherein a distance from an upper surface of the light emitting source to an apex of the first curved shape corresponds to the radius of curvature of the first curved shape.

4. The light emitting device according to one of the preceding claims, wherein the reflector includes a horizontal cross-sectional area gradually decreasing with increasing vertical distance from the upper surface of the substrate.

5. The light emitting device according to one of the preceding claims, wherein the front-light extractor further comprises the body including the first curved shape, a spacer extending from a lower distal end of the first curved shape in a vertical direction, and a neck disposed between the spacer and the body.

6. The light emitting device according to claim 5, wherein the body, the neck and the spacer are integrally formed with each other and comprise the same material.

7. The light emitting device according to claim 5 or 6, wherein the sum of a thickness of the spacer and a thickness of the neck with respect to the upper surface of the substrate is greater than or equal to a thickness of the light emitting source.

8. The light emitting device according to one of claims 5 to 7, wherein a circumference of a first horizontal cross-section of the neck in a region adjoining the body is less than a circumference of a second horizontal cross-section of the neck in a region adjoining the spacer.

9. The light emitting device according to one of claims 5-8, wherein the neck includes a third curved shape in at least a region thereof, the third curved shape including a smaller radius of curvature than the first curved shape.

10. The light emitting device according to claim 9, wherein the neck includes a third curved shape, the first curved shape including a radius of curvature five or more times the radius of curvature of the third curved shape.

11. The light emitting device according to one of the preceding claims, wherein the radius of curvature of the first curved shape is four or more times a thickness of the light emitting source.

12. The light emitting device according to one of claims 5 to 11, wherein the second curved shape includes a region of an ascending slope toward a center of the body.

13. The light emitting device according to one of the preceding claims, wherein the reflector includes a thickness gradually decreasing with increasing distance from a center of the light emitting source.

14. The light emitting device according to one of the preceding claims, wherein at least one side of the light emitting semiconductor device includes a first length (d1) and the first curved shape includes a first radius of curvature (R1), the first length (d1) and the first radius of curvature (R1) satisfying a relational equation of $-0.2083 \times (R1/d1)^2 + 0.5893 \times (R1/d1) + 0.6189 \geq 0.8$.

15. The light emitting device according to one of claims 5 to 14, wherein a difference between a distance from the upper surface of the light emitting source to an apex of the body of the front-light extractor and the radius of curvature (R1) is less than 10%.

【FIG. 1】

【FIG. 2】

【FIG. 3】

【FIG. 4】

【FIG. 5】

【FIG. 6】

【FIG. 7】

| | Europäisches Patentamt European Patent Office Office européen des brevets | **EUROPEAN SEARCH REPORT** | **Application Number** EP 24 17 2197 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 9 709 223 B2 (NICHIA CORP [JP]) 18 July 2017 (2017-07-18) * figures 1-5 * | 1-4,12, 14,15 | INV. H01L33/54 H01L33/60 |
| X | US 11 342 486 B2 (SUZHOU LEKIN SEMICONDUCTOR CO LTD [CN]) 24 May 2022 (2022-05-24) * figures 2,6 * | 1-15 | |
| X | JP 6 274240 B2 (NICHIA KAGAKU KOGYO KK) 7 February 2018 (2018-02-07) * figures 1,6,7 * | 1-4, 12-15 | |
| A | US 2015/270450 A1 (KUROKI TOSHIHIRO [JP] ET AL) 24 September 2015 (2015-09-24) * figures 1,2 * | 1 | |
| A | US 6 791 116 B2 (TOYODA GOSEI KK [JP]; MATSUSHITA ELECTRIC IND CO LTD [JP]) 14 September 2004 (2004-09-14) * figure 3 * | 1 | TECHNICAL FIELDS SEARCHED (IPC) |
| A | US 10 215 937 B1 (WU SHANG-YI [TW] ET AL) 26 February 2019 (2019-02-26) * figure 2 * | 1,5 | H01L |

The present search report has been drawn up for all claims

| Place of search | Date of completion of the search | Examiner |
|---|---|---|
| The Hague | 16 September 2024 | Gijsbertsen, Hans |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 17 2197

This annex lists the patent family members relating to the patent documents cited in the above-mentioned European search report.
The members are as contained in the European Patent Office EDP file on
The European Patent Office is in no way liable for these particulars which are merely given for the purpose of information.

16-09-2024

| Patent document cited in search report | | Publication date | Patent family member(s) | | Publication date |
|---|---|---|---|---|---|
| US 9709223 | B2 | 18-07-2017 | AU | 2013211571 A1 | 27-02-2014 |
| | | | AU | 2017225120 A1 | 28-09-2017 |
| | | | BR | 102013020170 A2 | 11-08-2015 |
| | | | CN | 103579466 A | 12-02-2014 |
| | | | CN | 108878623 A | 23-11-2018 |
| | | | EP | 2696377 A1 | 12-02-2014 |
| | | | JP | 5994472 B2 | 21-09-2016 |
| | | | JP | 2014036127 A | 24-02-2014 |
| | | | KR | 20140020789 A | 19-02-2014 |
| | | | KR | 20200089250 A | 24-07-2020 |
| | | | TW | 201409770 A | 01-03-2014 |
| | | | TW | 201727945 A | 01-08-2017 |
| | | | US | 2014042897 A1 | 13-02-2014 |
| | | | US | 2017250326 A1 | 31-08-2017 |
| US 11342486 | B2 | 24-05-2022 | US | 2020335673 A1 | 22-10-2020 |
| | | | WO | 2019088704 A1 | 09-05-2019 |
| JP 6274240 | B2 | 07-02-2018 | JP | 6274240 B2 | 07-02-2018 |
| | | | JP | 2016119494 A | 30-06-2016 |
| US 2015270450 | A1 | 24-09-2015 | CN | 104934520 A | 23-09-2015 |
| | | | JP | 2015179777 A | 08-10-2015 |
| | | | TW | 201537787 A | 01-10-2015 |
| | | | US | 2015270450 A1 | 24-09-2015 |
| US 6791116 | B2 | 14-09-2004 | CN | 1455462 A | 12-11-2003 |
| | | | KR | 20030085499 A | 05-11-2003 |
| | | | KR | 20050094802 A | 28-09-2005 |
| | | | TW | 595018 B | 21-06-2004 |
| | | | US | 2003214233 A1 | 20-11-2003 |
| US 10215937 | B1 | 26-02-2019 | CN | 110277477 A | 24-09-2019 |
| | | | CN | 207938641 U | 02-10-2018 |
| | | | TW | 201939768 A | 01-10-2019 |
| | | | US | 10215937 B1 | 26-02-2019 |

EPO FORM P0459

For more details about this annex : see Official Journal of the European Patent Office, No. 12/82